# EUROPEAN PATENT APPLICATION

(11) **EP 4 790 436 A1**
(43) Date of publication of application: **12.08.2026**
(21) Application number: 25189865.6
(22) Date of filing: 16.07.2025
(51) Int. Cl.: G01R 31/367, G01R 31/392

(54) **METHOD FOR DETERMINING STATE OF HEALTH OF BATTERY AND ELECTRONIC DEVICE**

(30) Priority: 07.02.2025 CN 202510138503
(71) Applicant: Eve Energy Co., Ltd., Huizhou, Guangdong 516006 (CN)
(72) Inventor: DONG, Yapeng, Huizhou, Guangdong, 516006 (CN); LIU, Junwen, Huizhou, Guangdong, 516006 (CN); LI, Wei, Huizhou, Guangdong, 516006 (CN); XIAO, Peng, Huizhou, Guangdong, 516006 (CN); SHANG, Jin, Huizhou, Guangdong, 516006 (CN); GUO, Qing, Huizhou, Guangdong, 516006 (CN)
(74) Representative: Berggren Oy

(57) **Abstract**

A method for determining a State of Health (SOH) battery and an electronic device are provided. The method includes: obtaining (101) a cyclic degradation amount of an SOH of a target battery within a previous usage cycle; obtaining (102) a calendar degradation amount of the SOH of the target battery between the previous usage cycle and a current usage cycle; determining (103) a total degradation amount of the SOH of the target battery within the previous usage cycle based on the cyclic degradation amount and the calendar degradation amount; and determining (104) a current SOH of the target battery based on the total degradation amount relating to the previous usage cycle. This application can reduce estimation errors of the battery's SOH.

## Description

### Technical Field

The present application relates to the field of battery technology, and specifically relates to a method for determining a State of Health of a battery and an electronic device.

### Background

Estimating a State of Health (SOH) of a battery has always been a challenging issue within the industry, with many SOH algorithms achieving only 10% accuracy. In related art, SOH can be estimated according to full charge and/or full discharge capacity of the battery. However, during actual battery usage, the probability of triggering the full charge and/or full discharge is relatively low, resulting in significant jumps in the estimated SOH, which in turn leads to substantial errors in SOH estimation.

### Summary

The present invention is defined in the independent claims as appended. Developments are set forth in the dependent claims.

The present invention provides a method for determining a State of Health (SOH) of a battery and an electronic device to reduce the battery's SOH estimation errors.

In a first aspect, the present invention provides a method for determining an SOH (SOH) of a battery, including:
obtaining a cyclic degradation amount of an SOH of a target battery within a previous usage cycle;
obtaining a calendar degradation amount of the SOH of the target battery between the previous usage cycle and a current usage cycle;
determining a total degradation amount of the SOH of the target battery within the previous usage cycle based on the cyclic degradation amount and the calendar degradation amount; and
determining a current SOH of the target battery based on the total degradation amount within the previous usage cycle.

In some embodiments, the obtaining of the cyclic degradation amount of the SOH of the target battery within the previous usage cycle includes:
obtaining a former cyclic capacity of the target battery within the previous usage cycle;
determining a former cyclic number of times of the target battery within the previous usage cycle based on the former cyclic capacity; and
determining the cyclic degradation amount of the SOH of the target battery within the previous usage cycle based on the former cyclic number of times.

In some embodiments, the determining of the cyclic degradation amount of the SOH of the target battery within the previous usage cycle based on the former cyclic number of times includes:
obtaining a former battery temperature of the target battery within the previous usage cycle; and
determining the cyclic degradation amount of the SOH of the target battery within the previous usage cycle based on the former battery temperature and the former cyclic number of times.

In some embodiments, the determining of the cyclic degradation amount of the SOH of the target battery within the previous usage cycle based on the former battery temperature and the former cyclic number of times includes:
determining, among preset cyclic degradation curves of a plurality of preset battery temperatures, a target cyclic degradation curve corresponding to the former battery temperature, wherein the target cyclic degradation curve comprises a correlation between SOH's and cyclic numbers of times of the target battery; and
determining, in accordance with the target cyclic degradation curve, the cyclic degradation amount of the SOH of the target battery within the previous usage cycle based on the former cyclic number of times.

In some embodiments, the obtaining of the calendar degradation amount of the SOH of the target batter between the previous usage cycle and the current usage cycle comprises:
obtaining a time difference between a start time of the current usage cycle and an end time of the previous usage cycle as a previous resting period of the target battery; and
determining the calendar degradation amount of the SOH of the target battery between the previous usage cycle and the current usage cycle based on the previous resting period.

In some embodiments, the determining of the calendar degradation amount of the SOH of the target battery between the previous usage cycle and the current usage cycle based on the previous resting period includes:
obtaining at least one of a state of charge (SOC) and a temperature of the target battery at the start time of the current usage cycle; and
determining the calendar degradation amount of the SOH of the target battery between the previous usage cycle and the current usage cycle based on the previous resting period and the at least one of the SOC and the temperature of the target battery.

In some embodiments, the determining of the calendar degradation amount of the SOH of the target battery between the previous usage cycle and the current usage cycle based on the previous resting period and the at least one of the SOC and the temperature of the target battery includes:
determining, among preset calendar degradation curves of a plurality of preset battery temperatures and/or preset SOC's, a target calendar degradation curve corresponding to the at least one of the SOC and the temperature of the target battery, wherein the target calendar degradation curve comprises a correlation between SOH's and resting periods of the target battery; and
determining, in accordance with the target calendar degradation curve, the calendar degradation amount of the SOH of the target battery between the previous usage cycle and the current usage cycle based on the previous resting period.

In some embodiments, each of the preset cyclic degradation curves includes a plurality of first curve segments sequentially concatenated, each of the first curve segments includes a correlation between SOH's and cyclic numbers of times of the target battery, and ranges of the SOH's in the first curve segments do not overlap with each other.

In some embodiments, each of the preset calendar degradation curves includes a plurality of second curve segments sequentially concatenated, each of the second curve segments includes a correlation between SOH's and resting periods of the target battery, and ranges of the SOH's in the second curve segments do not overlap with each other.

In a second aspect, the present invention further provides a device for determining an SOH of a battery, including:
a first acquisition module configured to obtain a cyclic degradation amount of an SOH of a target battery within a previous usage cycle;
a second acquisition module configured to obtain a calendar degradation amount of the SOH of the target battery between the previous usage cycle and a current usage cycle;
a first determination module configured to determine a total degradation amount of the SOH of the target battery within the previous usage cycle based on the cyclic degradation amount and the calendar degradation amount; and
a second determination module configured to determine a current SOH of the target battery based on the total degradation amount within the previous usage cycle.

In a third aspect, the present invention further provides an electronic device storing a computer program. This computer program is configured to be executed by a processor to implement any of the aforementioned methods for determining the SOH of the battery.

In some embodiments, the electronic device includes the processor and a memory, where the memory stores the computer program.

In some other embodiments, the electronic device is a computer storage medium.

In a fourth aspect, the present invention further provides a computer program product including a computer program or instructions. The program or instruction are executed by a processor to implement any of the aforementioned methods for determining the SOH of the battery.

The embodiments of the present invention provide the following beneficial effects.

In the embodiments of the present invention, the total degradation of the target battery's SOH within the previous usage cycle is comprehensively determined by acquiring the cyclic degradation amount of the target battery's SOH in the previous usage cycle and the calendar degradation amount between the previous and current usage cycles, on the basis of which the current SOH of the target battery is further determined. Compared to estimating the SOH through the battery's full charge and/or discharge capacity, the embodiments of the present invention integrate the cyclic degradation and calendar degradation amounts of the target battery. This allows for a more accurate determination of the total degradation amount of the target battery's SOH within the previous usage cycle. Additionally, this method can be triggered in each usage cycle of the target battery, ensuring that the estimated SOH monotonically decreases according to the total degradation amount of the previous usage cycle, resulting in smaller jumps and reduced estimation errors in SOH.

### Brief Description of the Drawings

In order to more clearly illustrate the technical solutions in the embodiments of the present invention, the accompanying drawings required for describing the embodiments will be briefly introduced below. It is apparent that the accompanying drawings in the following description are only some embodiments of the present invention. For those skilled in the art, other accompanying drawings can also be obtained based on these accompanying drawings without creative labour.
FIG. 1 is a flow chart of an exemplary method for determining a State of Health (SOH) of a battery provided by some embodiments of the present invention.
FIG. 2 is a flow chart of another exemplary method for determining the SOH of the battery provided by some embodiments of the present invention.
FIG. 3 is a schematic diagram illustrating preset cyclic degradation curves provided by some embodiments of the present invention.
FIG. 4a and FIG. 4b are other schematic diagrams illustrating the preset cyclic degradation curves provided by some embodiments of the present invention.
FIG. 5 is a flow chart of still another exemplary method for determining the SOH of the battery provided by some embodiments of the present invention.
FIG. 6a, FIG. 6b, and FIG. 6c are schematic diagrams illustrating preset calendar degradation curves provided by some embodiments of the present invention.
FIG. 7a, FIG. 7b, and FIG. 7c are schematic diagrams illustrating the preset calendar degradation curves provided by some embodiments of the present invention.
FIG. 8 is a flow chart of yet another exemplary method for determining the SOH of the battery provided by some embodiments of the present invention.
FIG. 9 shows exemplary curve formulas for respective preset cyclic degradation curves and preset calendar degradation curves provided by some embodiments of the present invention.
FIG. 10 shows exemplary curve segment formulas for respective preset cyclic degradation curves and preset calendar degradation curves provided by some embodiments of the present invention.
FIG. 11 is a structural diagram of an exemplary electronic device provided by some embodiments of the present invention.

### Detailed Description of the Embodiments

The technical solutions in the embodiments of the present invention will be clearly and completely described below in combination with the accompanying drawings in the embodiments of the present invention. It is apparent that the described embodiments are only part of the embodiments of the present invention, not all thereof. Based on the embodiments in the present invention, all other embodiments obtained by those skilled in the art without making creative labour are within the protection scope of the present invention. Furthermore, in the description of the present invention, the meaning of "a plurality of" refers to two or more unless otherwise specifically defined.

To reduce an estimation error of the battery's State of Health (SOH), some embodiments of the present invention provide a method for determining the SOH of the battery and an electronic device. The method involves obtaining a cyclic degradation amount of a target battery's SOH within a previous usage cycle and a calendar degradation amount of the target battery's SOH between the previous usage cycle and a current usage cycle, comprehensively determining a total degradation amount of the target battery's SOH within the previous usage cycle, and further determining a current SOH of the target battery. Compared with the SOH obtained by estimating the full charge and/or full discharge capacity of the battery, the embodiments of the present invention integrate the cyclic degradation amount and calendar degradation amount of the target battery, and thus allows for a more accurate determination of the total degradation amount of the target battery's SOH within the previous usage cycle. Additionally, the method of the present invention can be triggered in each usage cycle of the target battery. The estimated SOH decreases monotonically according to the total degradation amount from the previous usage cycle, resulting in smaller jumps and reduced estimation errors. For specific solutions, please refer to the detailed description below.

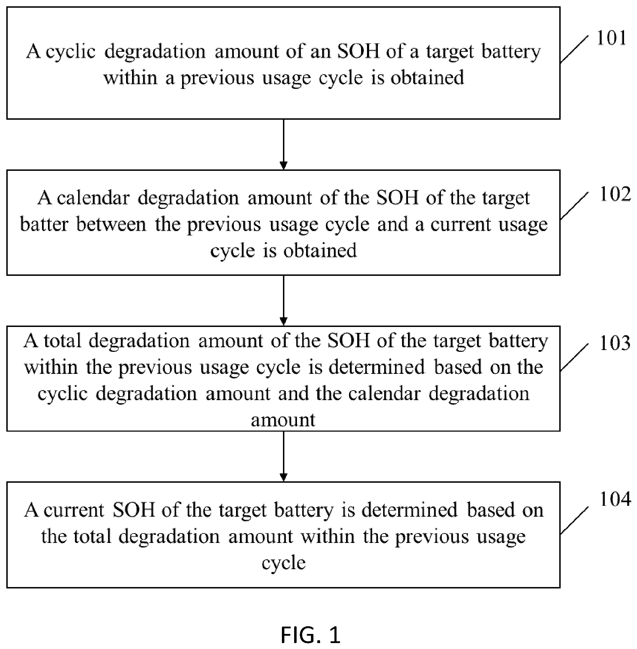

In a first aspect, some embodiments of the present invention provide methods for determining an SOH of a battery. Specifically, referring to FIG. 1. FIG. 1 is a flow chart of an exemplary method for determining an SOH of a battery. In FIG. 1, the method for determining the battery's SOH may include following operations 101 to 104.

In 101, a cyclic degradation amount of an SOH of a target battery within a previous usage cycle is obtained.

In some embodiments of the present invention, the target battery may be any battery of a Battery Management System (BMS), and the SOH of the target battery needs to be estimated to facilitate management of the target battery. The target battery can be, for example, a consumer battery, an energy storage battery, a power battery, etc. The target battery has corresponding usage cycles within different stages. For example, a period between each powering on and an immediately subsequent powering off of the target battery can be used as a usage cycle. Therefore, the previous usage cycle of the target battery may be a period between a previous powering on and a corresponding powering off immediately after the previous powering on.

The cyclic degradation of the target battery's SOH within the previous usage cycle refers to a degradation amount of the target battery's SOH due to charging and discharging of the target battery within the previous usage cycle. It can be understood that when the target battery is being charged or is discharging, the target battery's SOH will degrade. Hence, the degradation amount of the target battery' SOH during charging or discharging can be used as the cyclic degradation amount.

In 102, a calendar degradation amount of the SOH of the target batter between the previous usage cycle and a current usage cycle is obtained.

In some embodiments of the present invention, the calendar degradation amount of the target battery's SOH refers to a degradation amount of the target battery's SOH when the target battery is in an unused state (i.e., a resting state). Since the target battery is in the unused state between the previous usage cycle and the current usage cycle, it is possible to determine the calendar degradation amount of the target battery's SOH between the previous and current usage cycles. Therefore, the method for determining the SOH of the battery in the embodiments of the present invention is performed within the current usage cycle, for example, only after the target battery is powered on.

In 103, a total degradation amount of the SOH of the target battery within the previous usage cycle is determined based on the cyclic degradation amount and the calendar degradation amount.

In some embodiments of the present invention, the total degradation amount within the previous usage cycle of the target battery's SOH refers to a total degradation amount of the target battery's SOH from a beginning of the previous usage cycle to a beginning of the current usage cycle. For example, a sum of the cyclic degradation amount of the target battery's SOH in the previous usage cycle and the calendar degradation amount between the previous usage cycle and the current usage cycle may be used as the total degradation amount of the target battery's SOH within the previous usage cycle.

In 104, a current SOH of the target battery is determined based on the total degradation amount within the previous usage cycle.

In some embodiments of the present invention, according to the downhill theory, the total degradation of the battery's SOH is an accumulation of degradation at each step. Therefore, the current SOH of the target battery can be obtained by subtracting the total degradation amount within the previous usage cycle from a most recently recorded SOH of the target battery. This method allows the current SOH of the target battery to decrease monotonically, resulting in smaller jumps. The most recently recorded SOH of the target battery can be stored in memory of the BMS.

The most recently recorded SOH of the target battery can be a current SOH of the target battery determined last time. For example, the most recently recorded SOH of the target battery may be a current SOH of the target battery within a usage cycle immediately prior to the previous usage cycle of the target battery. In this way, the current SOH of the target battery can be updated at the beginning of each usage cycle to ensure that a SOH degradation within each usage cycle of the target battery is calculated and considered. It can be seen that it is possible to trigger the determination of the current SOH of the target battery within each usage cycle of the target battery, improving a trigger frequency. An initial value of the most recently recorded SOH of the target battery can be 100%, that is, when the current usage cycle of the target battery is the target battery's first service cycle, the most recently recorded SOH of the target battery is 100%.

It can be seen that in the above-mentioned embodiment of the present invention, by integrating the cyclic degradation amount and the calendar degradation amount of the target battery, the total degradation amount of the previous usage cycle can be determined more accurately. This method can be triggered in each usage cycle of the target battery, allowing the estimated SOH to decrease monotonically according to the total degradation amount within the previous usage cycle. This results in smaller jumps, aligning more closely with the natural degradation pattern of SOH, and reducing estimation errors.

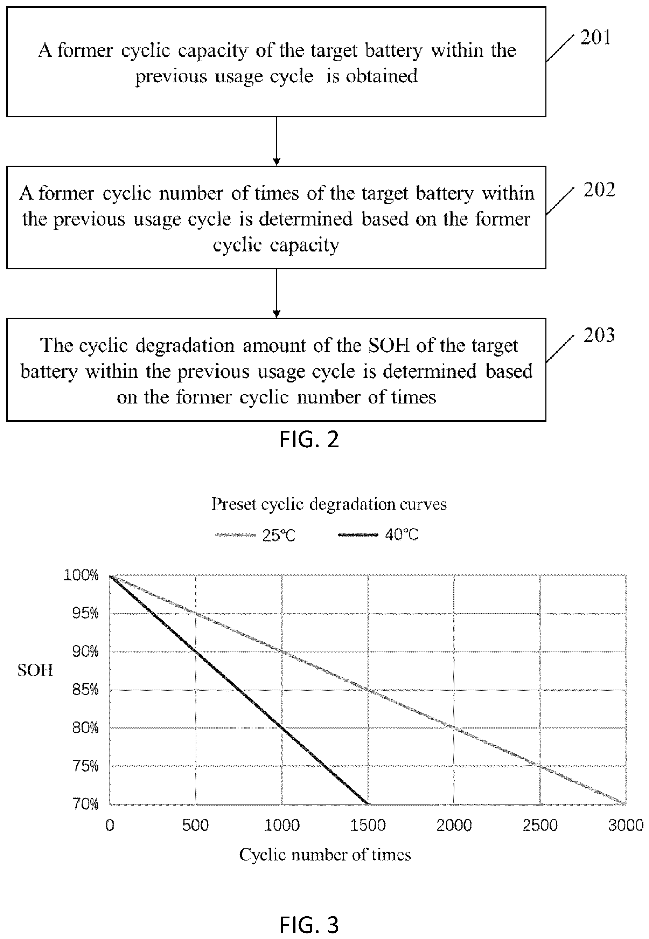

In some embodiments of the present invention, as shown in FIG. 2, the obtaining of the cyclic degradation amount of the SOH of the target battery within the previous usage cycle may include operations 201-203.

In 201, a former cyclic capacity of the target battery within the previous usage cycle is obtained.

In some embodiments of the present invention, the former cyclic capacity of the target battery within the previous usage cycle refers to a total charging and/or discharging power amount of the target battery in the previous usage cycle, for example, any one of the target battery's total charging amount, the target battery's total discharging amount, or a sum of the target battery's total charging amount and total discharging amount in the previous usage cycle.

In 202, a former cyclic number of times of the target battery within the previous usage cycle is determined based on the former cyclic capacity.

In some embodiments of the present invention, a cyclic number of times corresponding to the former cyclic capacity can be determined based on a correlation between cyclic capacities and cyclic numbers of times, as the former cyclic number of times of the target battery in the previous usage cycle. The correlation between the cyclic capacities and the cyclic numbers of times, for example:$Δ n = {Q / AQ}_{0} ,$
where Δn represents the cyclic number of times, Q represents the cyclic capacity, A represents charging and/or discharging efficiency of the target battery which may be for example 0.9 or 0.85, and Q0 represents rated capacity of the target battery.

In 203, the cyclic degradation amount of the SOH of the target battery within the previous usage cycle is determined based on the former cyclic number of times.

In some embodiments of the present invention, the cyclic degradation amount of the target battery within the previous usage cycle can be determined based on a correlation between the cyclic numbers of times and the cyclic degradation amounts. The correlation between the cyclic numbers of times and the cyclic degradation amounts is not limited here.

In some embodiments of the present invention, since the temperature of the target battery will affect the cyclic degradation amount of the target battery's SOH, it is possible to combine the temperature of the target battery to more accurately determine the cyclic degradation amount of the target battery's SOH within the previous usage cycle. Specifically, the operation 203 may include: obtaining a former battery temperature of the target battery within the previous usage cycle, which can be at least one of a former average temperature, a former highest temperature, and a former lowest temperature of the target battery within the previous usage cycle; and determining the cyclic degradation amount of the SOH of the target battery within the previous usage cycle based on the former battery temperature and the former cyclic number of times, to achieve a more accurate cyclic degradation amount.

In some embodiments of the present invention, a cyclic degradation curve may be used to determine the cyclic degradation amount. Specifically, the determining of the cyclic degradation amount of the SOH of the target battery within the previous usage cycle based on the former battery temperature and the former cyclic number of times may include: determining, among preset cyclic degradation curves of a plurality of preset battery temperatures, a target cyclic degradation curve corresponding to the former battery temperature. The target cyclic degradation curve includes a correlation between SOH's and cyclic numbers of times of the target battery. For example, as shown in FIG. 3, preset cyclic degradation curves under the preset battery temperatures of 25°C and 40°C are shown. In FIG. 3, a horizontal coordinate of each preset cyclic degradation curve represents the cyclic numbers of times, and a vertical coordinate represents the SOH. The determining of the cyclic degradation amount of the SOH of the target battery within the previous usage cycle based on the former battery temperature and the former cyclic number of times may further include: determining, in accordance with the target cyclic degradation curve, the cyclic degradation amount of the SOH of the target battery within the previous usage cycle based on the former cyclic number of times. For example, a cyclic number of times corresponding to the most recently recorded SOH of the target battery can be determined from the target cyclic degradation curve, and then a sum of the cyclic number of times corresponding to the most recently recorded SOH of the target battery and the former cyclic number of times is determined as a new cyclic number of times. A new SOH corresponding to the new cyclic number of times is determined from the target cyclic degradation curve, and a difference between the most recently recorded SOH of the target battery and the new SOH is determined as the cyclic degradation amount of the target battery's SOH within the previous usage cycle.

It can be seen that using the cyclic degradation curve to determine the cyclic degradation amount can facilitate the determination of the cyclic degradation amount.

The preset cyclic degradation curve corresponding to each preset battery temperature can be obtained by fitting preliminary experimental data. For example, a preset battery can be placed in an environment with the preset temperature during preliminary experiments and can be charged and discharged alternately. The SOH of the battery is measured after each cycle. A linear fit is then used to derive the cyclic degradation curve corresponding to the preset battery temperature.

In some embodiments of the present invention, for some types of target batteries (such as ternary or lithium iron phosphate batteries), a degradation trend of the SOH relative to the cyclic number of times may exhibit weak linearity. In such cases, a piecewise fitting approach can be employed to determine the preset cyclic degradation curve corresponding to each preset battery temperature. Specifically, the preset cyclic degradation curve includes a plurality of first curve segments sequentially concatenated, each first curve segment includes a correlation between SOH's and cyclic numbers of times of the target battery, and ranges of the SOH's in the first curve segments do not overlap with each other. For example, each preset cyclic degradation curve includes three first curve segments concatenated in sequence, SOH value ranges in the three first curve segments are 90%<SOH≤100%, 80%<SOH≤90%, and SOH≤80% in sequence. The three first curve segments represent a Beginning of Life (BOL) stage (90%<SOH≤100%), a Middle of Life (MOL) stage (80%<SOH≤90%), and an End of Life (EOL) stage (SOH≤80%) in sequence.

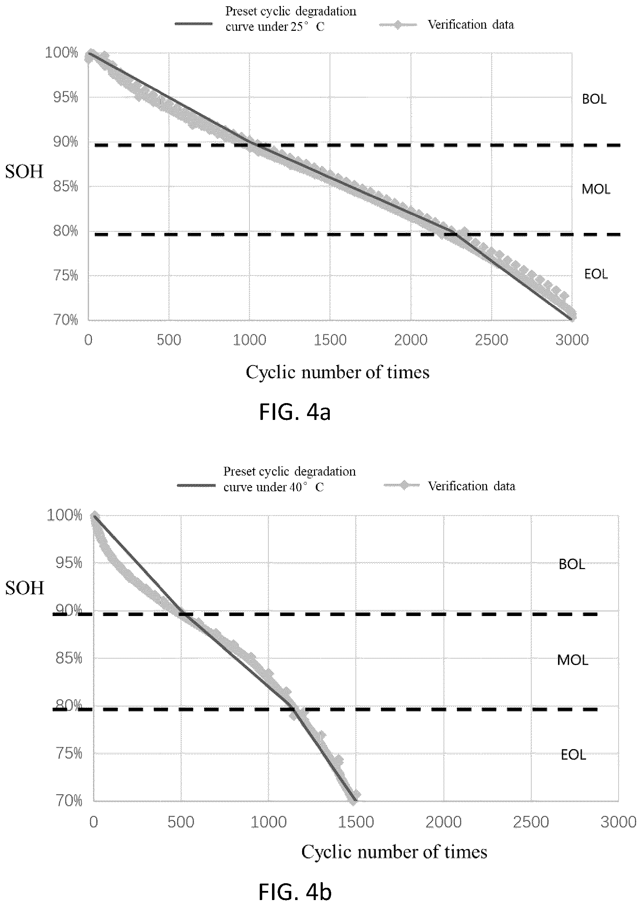

It can be seen that using the piecewise fitting to determine the preset cyclic degradation curve can make the preset cyclic degradation curve more in line with actual situations and more accurate. For example, FIG. 4a shows a preset cyclic degradation curve obtained through the piecewise linear fitting under the preset battery temperature of 25°C. The preset cyclic degradation curve has a high degree of fit with verification data corresponding to the preset battery temperature of 25°C. For example, FIG. 4b shows a preset cyclic degradation curve obtained through the piecewise linear fitting under the preset battery temperature of 40°C. The preset cyclic degradation curve has a high degree of fit with verification data corresponding to the preset battery temperature of 40°C.

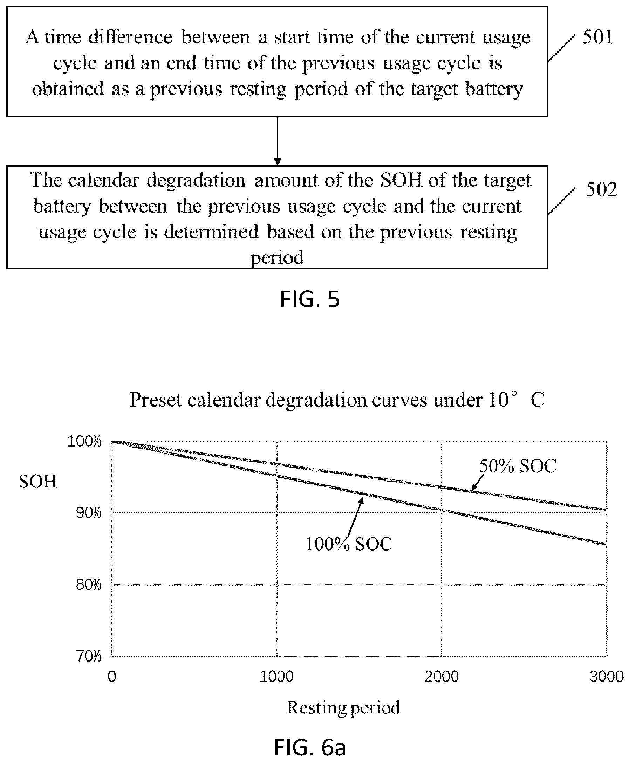

In some embodiments of the present invention, as shown in FIG. 5, the obtaining of the calendar degradation amount of the target battery's SOH between the previous usage cycle and the current usage cycle may include operations 501-502.

In 501, a time difference between a start time of the current usage cycle and an end time of the previous usage cycle is obtained as a previous resting period of the target battery.

In some embodiments of the present invention, since the calendar degradation amount of the target battery's SOH refers to a degradation amount of the target battery's SOH in the unused state (i.e., the resting state) of the target battery, the time difference between the start time of the current usage cycle and the end time of the previous usage cycle can be used as the previous resting period of the target battery.

In 502, the calendar degradation amount of the SOH of the target battery between the previous usage cycle and the current usage cycle is determined based on the previous resting period.

In some embodiments of the present invention, the calendar degradation amount of the target battery's SOH between the previous usage cycle and the current usage cycle can be determined based on a correlation between resting periods and the calendar degradation amounts. The correlation between the resting periods and the calendar degradation amounts is not limited here.

In some embodiments of the present invention, the calendar degradation amount of the target battery's SOH can also be affected by the target battery's temperature and state of charge (SOC). Therefore, the calendar degradation amount of the target battery's SOH can be more accurately determined in combination with at least one of the target battery's temperature and SOC. Specifically, the operation 502 may further include: obtaining at least one of an SOC and a temperature of the target battery at the start time of the current usage cycle; and determining the calendar degradation amount of the SOH of the target battery between the previous usage cycle and the current usage cycle based on the previous resting period and the at least one of the SOC and the temperature of the target battery, to achieve a more accurate calendar degradation amount.

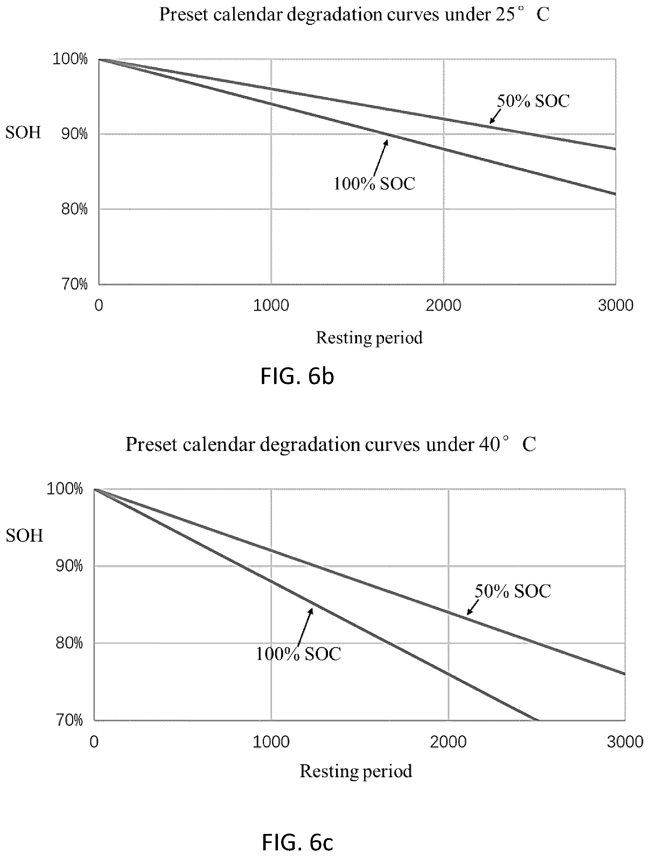

In some embodiments of the present invention, a calendar degradation curve may be used to determine the calendar degradation amount. Specifically, the determining of the calendar degradation amount of the SOH of the target battery between the previous usage cycle and the current usage cycle based on the previous resting period and the at least one of the SOC and the temperature of the target battery can include: determining, among preset calendar degradation curves of a plurality of preset battery temperatures and/or preset SOC's, a target calendar degradation curve corresponding to the at least one of the SOC and the temperature of the target battery The target calendar degradation curve includes a correlation between SOH's and resting periods of the target battery. For example, as shown in FIG. 6a, preset calendar degradation curves under a preset battery temperature of 10°C with preset SOC's at 100% and 50% are shown. Similarly, FIG. 6b shows preset calendar degradation curves under a preset battery temperature of 25°C with preset SOC's at 100% and 50%, and FIG. 6c shows preset calendar degradation curves under a preset battery temperature of 40°C with preset SOC's at 100% and 50%. In FIGS. 6a, 6b, and 6c, a horizontal axis of each preset calendar degradation curve represents the resting period (in days), and the vertical axis represents the SOH. The determining of the calendar degradation amount of the SOH of the target battery between the previous usage cycle and the current usage cycle based on the previous resting period and the at least one of the SOC and the temperature of the target battery can include: determining, in accordance with the target calendar degradation curve, the calendar degradation amount of the SOH of the target battery between the previous usage cycle and the current usage cycle based on the previous resting period. For example, a resting period corresponding to the most recently recorded SOH of the target battery can be determined from the target calendar degradation curve, and then a sum of the resting period and the previous resting period is determined as a new resting period. A new SOH corresponding to the new resting period is determined from the target calendar degradation curve, and a difference between the most recently recorded SOH of the target battery and the new SOH is determined as the calendar degradation amount of the target battery's SOH between the previous usage cycle and the current usage cycle.

It can be seen that using the calendar degradation curve to determine the calendar degradation amount can facilitate the determination of the calendar degradation amount.

The preset calendar degradation curve corresponding to each preset battery temperature and/or the preset SOC can be obtained by fitting preliminary experimental data. For example, the preset battery with the preset SOC can be placed in an environment with a preset temperature during preliminary experiments. By allowing the target battery to rest (i.e., absent of charge and discharge cycle), the SOH of the battery is measured after different resting periods. A linear fit is then used to derive the calendar degradation curve corresponding to that preset battery temperature and/or SOC.

In some embodiments of the present invention, for some types of target batteries (such as ternary or lithium iron phosphate batteries), a degradation trend of the SOH relative to the resting period may exhibit weak linearity. In such cases, a piecewise fitting approach can be employed to determine the preset calendar degradation curve corresponding to each preset battery temperature and/or SOC. Specifically, the preset calendar degradation curve includes a plurality of second curve segments sequentially concatenated, each second curve segment includes an correlation between the SOH's and resting periods of the target battery, and ranges of the SOH's in the second curve segments do not overlap with each other. For example, each preset calendar degradation curve includes three second curve segments concatenated in sequence, SOH value ranges in the three second curve segments are 90%<SOH≤100%, 80%<SOH≤90%, SOH≤80% in sequence. The three second curve segments a Beginning of Life (BOL) stage (90%<SOH≤100%), a Middle of Life (MOL) stage (80%<SOH≤90%), and an End of Life (EOL) stage (SOH≤80%) in sequence.

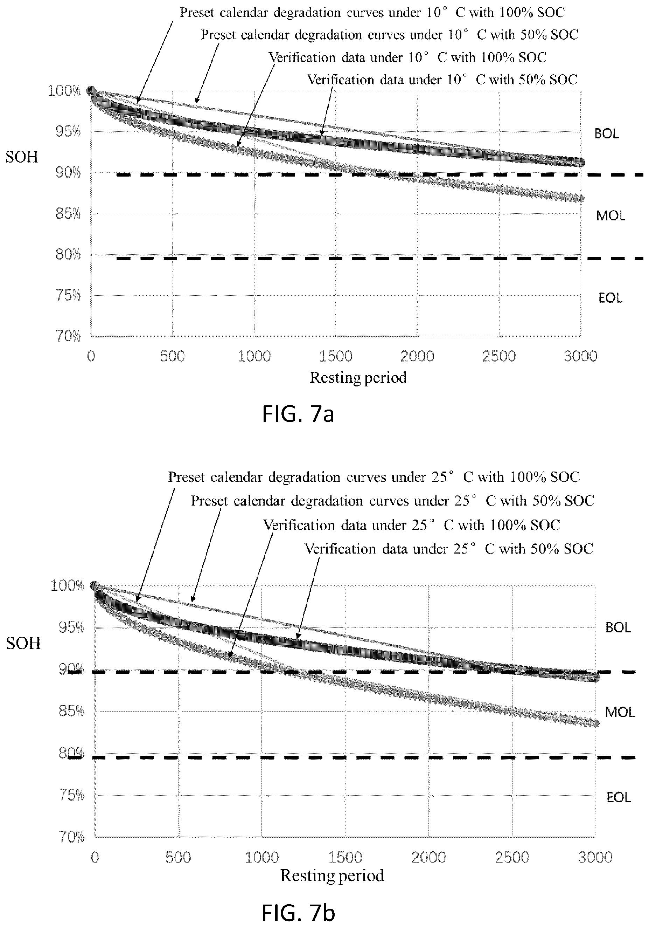

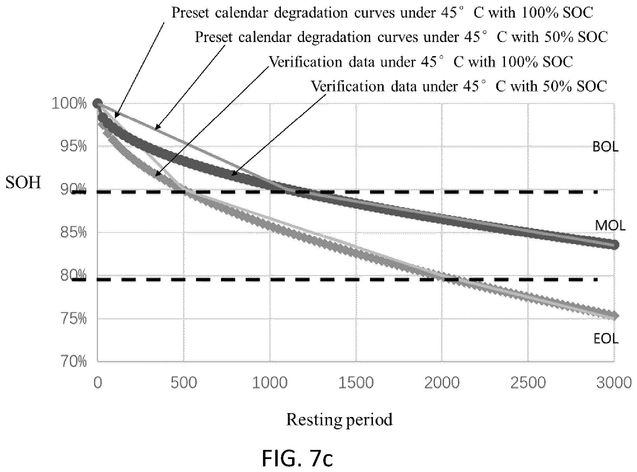

It can be seen that using piecewise fitting to determine the preset calendar degradation curve can make the preset calendar degradation curve more in line with actual situations and more accurate. For example, FIG. 7a shows preset calendar degradation curves obtained through the piecewise linear fitting under the preset battery temperature of 10°C with the preset SOC's respectively at 100% and 50%. The preset calendar degradation curves are highly fitted with the respective verification data. For example, FIG. 7b shows preset calendar degradation curves obtained through the piecewise linear fitting under the preset battery temperature of 25°C with the preset SOC's respectively at 100% and 50%. The preset calendar degradation curves are also highly fitted with the respective verification data. For example, FIG. 7c shows preset calendar degradation curves obtained through the piecewise linear fitting under the preset battery temperature of 45°C with the preset SOC's respectively at 100% and 50%. The preset calendar degradation curves are also highly fitted with the respective verification data.

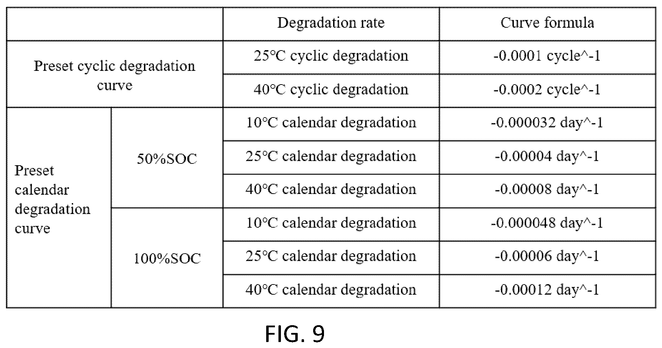

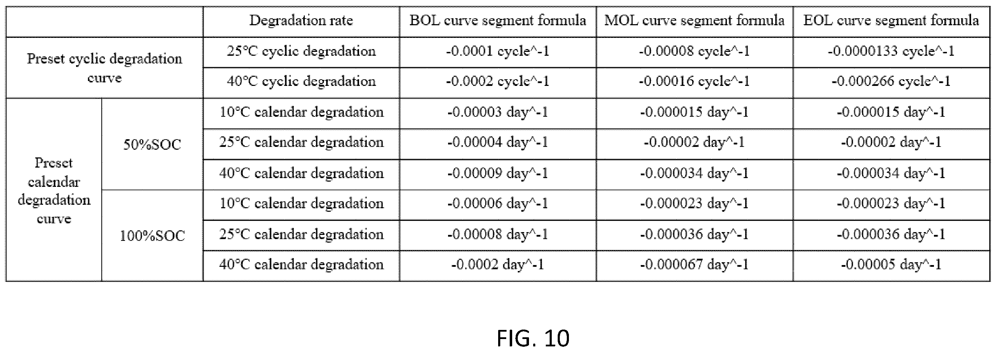

In some embodiments of the present invention, curve formulas for the preset cyclic degradation curves and the preset calendar degradation curves obtained through direct linear fitting are shown in FIG. 9, and curve fragment formulas for the preset cyclic degradation curves and the preset calendar degradation curves obtained through the piecewise fitting are shown in FIG. 10. In FIGS. 9-10, "cycle" represents the cyclic number of times and "day" represents the resting period.

For the colour versions of FIGS. 3, 4a, 4b, 6a, 6b, 6c, 7a, 7b and 7c, reference may be made to the published pamphlet of the priority application (publication number: CN202510138503.3) of the present application.

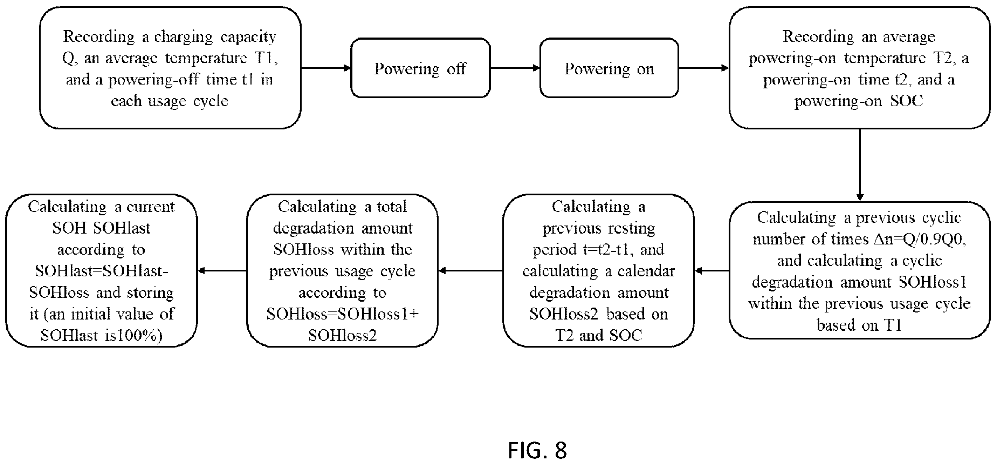

In some embodiments of the present invention, referring to FIG. 8, a method for determining the battery's SOH of the above-mentioned embodiments will be exemplified. Specifically, in each usage cycle of the target battery, a charging capacity Q, an average temperature T1, and a powering-off time t1 of the target battery are recorded, and after the target battery is powered off and then powered on, a new usage cycle is entered. At this time, an average powering-on temperature T2, a powering-on time t2, and a powering-on SOC of the target battery are recorded.

A previous cyclic number of times Δn is determined according to Δn=Q/0.9Q0 and is taken as the former cyclic number of times of the target battery within the previous usage cycle. The average temperature T1 is used as the former battery temperature of the target battery in the previous usage cycle. Based on the former battery temperature and the former cyclic number of times, the cyclic degradation amount SOHloss1 of the target battery's SOH in the previous usage cycle is determined.

The target battery's previous resting period t is calculated according to t=t2-t1. The powering-on average temperature T2 is used as the battery temperature of the target battery at the start time of the current usage cycle, and the powering-on SOC is used as the SOC of the target battery at the start time of the current usage cycle. Based on the previous resting period and at least one of the SOC and battery temperature, the calendar degradation amount SOHloss2 of the target battery's SOH between the previous usage cycle and the current usage cycle is determined.

Based on the cyclic degradation amount and the calendar degradation amount, the total degradation amount SOHloss within the previous usage cycle of the target battery is calculated according to SOHloss=SOHloss1+SOHloss2.

The current SOH denoted as SOHlast of the target battery is determined according to SOHlast=SOHlast-SOHloss and is stored in the memory of the BMS. An initial value of SOHlast can be 100%.

It can be seen that in the above-mentioned embodiment of the present invention, the total degradation amount of the target battery within the previous usage cycle can be determined more accurately by considering both the cyclic degradation amount and calendar degradation amount of target battery's SOH. This process can be triggered in each usage cycle of the target battery, allowing the estimated SOH to decrease monotonically according to the total degradation amount within the previous usage cycle. This results in smaller jumps and reduces estimation errors.

Moreover, the above-mentioned embodiments of the present invention further provide different operating conditions for the target battery. By integrating the former cyclic capacity, the battery temperature, and the state of charge (SOC), the corresponding degradation amount of the target battery's SOH can be calculated separately, avoiding relying on a single curve to represent all operating conditions of the target battery. Consequently, the calculated corresponding degradation amount of the target battery's SOH will be more accurate.

In a second aspect, based on the method for determining the SOH of the battery of the above-mentioned embodiments, some embodiments of the present invention further provide a device for determining the SOH of the battery, and the device is configured to perform operations in any embodiments within the method for determining the SOH of the battery. For example, the device for determining the SOH of the battery may include:
a first acquisition module configured to obtain a cyclic degradation amount of an SOH of a target battery within a previous usage cycle;
a second acquisition module configured to obtain a calendar degradation amount of the SOH of the target battery between the previous usage cycle and a current usage cycle;
a first determination module configured to determine a total degradation amount of the SOH of the target battery within the previous usage cycle based on the cyclic degradation amount and the calendar degradation amount; and
a second determination module configured to determine a current SOH of the target battery based on the total degradation amount within the previous usage cycle.

In a third aspect, some embodiments of the present invention further provide an electronic device stored with a computer program, which is configured to be executed by a processor to implement the method for determining the SOH of the battery as described in any one of the above embodiments.

In some embodiments of the present invention, the electronic device integrates device for determining the battery's SOH provided by any embodiment of the present invention. The electronic device includes a processor and a memory storing a computer program, which is configured to be executed by the processor to implement the method for determining the SOH of the battery as described in any of the above embodiments, for example, including:
obtaining a cyclic degradation amount of an SOH of a target battery within a previous usage cycle; obtaining a calendar degradation amount of the SOH of the target battery between the previous usage cycle and a current usage cycle; determining a total degradation amount of the SOH of the target battery within the previous usage cycle based on the cyclic degradation amount and the calendar degradation amount; and determining a current SOH of the target battery based on the total degradation amount within the previous usage cycle.

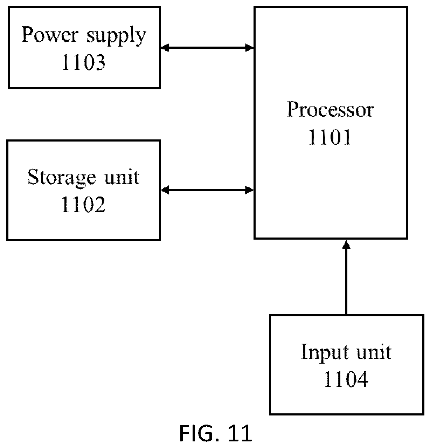

In some embodiments of the present invention, as shown in FIG. 11, a structural diagram of the electronic device relating to the embodiments of the present invention is shown.

In particular, the electronic device may include one or more processors 1101 of processing cores, one or more storage units 1102 of one or more computer readable storage media, a power supply 1103, and an input unit 1104, etc. Those skilled in the art will appreciate that the electronic device is not limited to the electronic device structure shown in FIG. 11 and may include more or less components than the illustration, or combine certain components, or have different component arrangements.

The processor 1101 is the control centre of the electronic device, and connects all parts of the electronic device through various interfaces and lines. By running or executing the software programs and/or modules stored in the storage unit 1102, and by calling the data stored in storage units 1102, the processor 1101performs various functions and processes data of the electronic device, thereby conducting overall monitoring of the electronic device. Optionally, the processor 1101 can include one or more processing cores; preferably, the processor 1101 can integrate an application processor and a modem processor, where the application processor mainly handles the operating system, user interface and applications, etc., and the modem processor mainly handles wireless communication. It is understood that the above modem processor may not be integrated into processor 1101.

The storage unit 1102 can be used to store software programs and modules. The processor 1101 runs the software programs and/or modules stored in the storage units 1102, thereby executing various functional applications and data processing. The storage unit 1102 mainly includes a program storage area and a data storage area. The program storage area can store the operating system, at least one application required for a function (such as a sound playback function, an image playback function, etc.). The data storage area can store data created based on the use of the electronic device, etc. Additionally, the storage unit 1102 can include a high-speed random access memory, and can further include non-volatile memory, such as at least one disk storage device, flash memory device, or other volatile solid-state storage device. Correspondingly, the storage unit 1102 can further include a memory controller to provide the processor 1101 with access to the storage unit 1102.

The electronic device further includes the power supply 1103 for powering various components. Preferably, the power supply 1103 can be logically connected to processor 1101 through a battery management system (BMS), thereby enabling management of charging, discharging, and power consumption management functions through the BMS. The power supply 1103 can further include any component of one or more DC or AC power sources, recharging systems, power failure detection circuits, power converters or inverters, power status indicators, etc.

The electronic device can further include the input unit 1104, which can be used to receive input of digital or character information, as well as generate keyboard, mouse, joystick, optical or trackball signal inputs related to user settings and function control.

Although not shown, the electronic device can further include a display unit, etc. This will not be further elaborated here. Specifically in some embodiments of the present invention embodiment, the processor 1101 of the electronic device will, according to the following instructions, load one or more application process corresponding executable files into the storage unit 1102, and run the applications stored in the storage unit 1102 by the processor 1101, thereby achieving various functions, for example, including:
obtaining a cyclic degradation amount of the SOH of a target battery within a previous usage cycle; obtaining a calendar degradation amount of the SOH of the target battery between the previous usage cycle and a current usage cycle; determining a total degradation amount of the SOH of the target battery within the previous usage cycle based on the cyclic degradation amount and the calendar degradation amount; and determining a current SOH of the target battery based on the total degradation amount within the previous usage cycle.

In some embodiments of this application, the electronic device provided by the application is a computer storage medium. This computer-readable storage medium can include Read Only Memory (ROM), Random Access Memory (RAM), disk or optical disc, etc. This computer-readable storage medium stores a computer program, and the computer program is configured to be executed by the processor to achieve the determination method of the battery health status as described in any of the above items, for example, including:
obtaining a cyclic degradation amount of the SOH of a target battery within a previous usage cycle; obtaining a calendar degradation amount of the SOH of the target battery between the previous usage cycle and a current usage cycle; determining a total degradation amount of the SOH of the target battery within the previous usage cycle based on the cyclic degradation amount and the calendar degradation amount; and determining a current SOH of the target battery based on the total degradation amount within the previous usage cycle.

In some embodiments of the present invention, the electronic device provided by the embodiments of the present invention is a computer storage medium, which may include: Read Only Memory (ROM), Random Access Memory (RAM), magnetic disk or optical disk, etc. The computer readable storage medium stores a computer program configured to be executed by a processor to implement the method for determining the SOH of the battery as described in any one of the above embodiments, for example, including:
obtaining a cyclic degradation amount of the SOH of a target battery within a previous usage cycle; obtaining a calendar degradation amount of the SOH of the target battery between the previous usage cycle and a current usage cycle; determining a total degradation amount of the SOH of the target battery within the previous usage cycle based on the cyclic degradation amount and the calendar degradation amount; and determining a current SOH of the target battery based on the total degradation amount within the previous usage cycle.

In a fourth aspect, some embodiments of the present invention further provide a computer program product including a computer program or instructions, which are executed by a processor to implement the method for determining the SOH of the battery as described in any one of the above embodiments, for example, including:
obtaining a cyclic degradation amount of the SOH of a target battery within a previous usage cycle; obtaining a calendar degradation amount of the SOH of the target battery between the previous usage cycle and a current usage cycle; determining a total degradation amount of the SOH of the target battery within the previous usage cycle based on the cyclic degradation amount and the calendar degradation amount; and determining a current SOH of the target battery based on the total degradation amount within the previous usage cycle.

The above provides a detailed introduction to some embodiments of the present invention. In this article, specific examples have been applied to explain the principle and implementation methods of the present invention. The explanations of the above embodiments are only intended to help understand the method and core idea of the present invention. However, for those skilled in the art, based on the idea of the present invention, there will be changes in specific implementation methods and application scope. In conclusion, the content of this specification should not be understood as a limitation of the present invention.

## Claims

1. A method for determining a state of health (SOH) of a battery, comprising:
obtaining (101) a cyclic degradation amount of the SOH of a target battery within a previous usage cycle;
obtaining (102) a calendar degradation amount of the SOH of the target battery between the previous usage cycle and a current usage cycle;
determining (103) a total degradation amount of the SOH of the target battery within the previous usage cycle based on the cyclic degradation amount and the calendar degradation amount; and
determining (104) a current SOH of the target battery based on the total degradation amount within the previous usage cycle.

2. The method for determining the SOH of the battery according to claim 1, wherein the obtaining of the cyclic degradation amount of the SOH of the target battery within the previous usage cycle comprises:
obtaining (201) a former cyclic capacity of the target battery within the previous usage cycle;
determining (202) a former cyclic number of times of the target battery within the previous usage cycle based on the former cyclic capacity; and
determining (203) the cyclic degradation amount of the SOH of the target battery within the previous usage cycle based on the former cyclic number of times.

3. The method for determining the SOH of the battery according to claim 2, wherein the determining (203) of the cyclic degradation amount of the SOH of the target battery within the previous usage cycle based on the former cyclic number of times comprises:
obtaining a former battery temperature of the target battery within the previous usage cycle; and
determining the cyclic degradation amount of the SOH of the target battery within the previous usage cycle based on the former battery temperature and the former cyclic number of times.

4. The method for determining the SOH of the battery according to claim 3, wherein the determining of the cyclic degradation amount of the SOH of the target battery within the previous usage cycle based on the former battery temperature and the former cyclic number of times comprises:
determining, among preset cyclic degradation curves of a plurality of preset battery temperatures, a target cyclic degradation curve corresponding to the former battery temperature, wherein the target cyclic degradation curve comprises a correlation between SOH's and cyclic numbers of times of the target battery; and
determining, in accordance with the target cyclic degradation curve, the cyclic degradation amount of the SOH of the target battery within the previous usage cycle based on the former cyclic number of times.

5. The method for determining the SOH of the battery according to claim 1, wherein the obtaining (102) of the calendar degradation amount of the SOH of the target batter between the previous usage cycle and the current usage cycle comprises:
obtaining (501) a time difference between a start time of the current usage cycle and an end time of the previous usage cycle as a previous resting period of the target battery; and
determining (502) the calendar degradation amount of the SOH of the target battery between the previous usage cycle and the current usage cycle based on the previous resting period.

6. The method for determining the SOH of the battery according to claim 5, wherein the determining (502) of the calendar degradation amount of the SOH of the target battery between the previous usage cycle and the current usage cycle based on the previous resting period comprises:
obtaining at least one of a state of charge (SOC) and a temperature of the target battery at the start time of the current usage cycle; and
determining the calendar degradation amount of the SOH of the target battery between the previous usage cycle and the current usage cycle based on the previous resting period and the at least one of the SOC and the temperature of the target battery.

7. The method for determining the SOH of the battery according to claim 6, wherein the determining of the calendar degradation amount of the SOH of the target battery between the previous usage cycle and the current usage cycle based on the previous resting period and the at least one of the SOC and the temperature of the target battery comprises:
determining, among preset calendar degradation curves of a plurality of preset battery temperatures and/or preset SOC's, a target calendar degradation curve corresponding to the at least one of the SOC and the temperature of the target battery, wherein the target calendar degradation curve comprises a correlation between SOH's and resting periods of the target battery; and
determining, in accordance with the target calendar degradation curve, the calendar degradation amount of the SOH of the target battery between the previous usage cycle and the current usage cycle based on the previous resting period.

8. The method for determining the SOH of the battery according to claim 4, wherein each of the preset cyclic degradation curves comprises a plurality of first curve segments sequentially concatenated, each of the first curve segments comprising a correlation between SOH's and cyclic numbers of times of the target battery, and ranges of the SOH's in the first curve segments do not overlap with each other.

9. The method for determining the SOH of the battery according to claim 7, wherein each of the preset calendar degradation curves comprises a plurality of second curve segments sequentially concatenated, each of the second curve segments comprising a correlation between SOH's and resting periods of the target battery, and ranges of the SOH's in the second curve segments do not overlap with each other.

10. An electronic device storing a computer program configured to be executed by a processor (1101) to implement a method for determining a state of health (SOH) of a battery as claimed in any one of claims 1 to 9.
